# EUROPEAN PATENT SPECIFICATION

(11) **EP 0 740 072 B1**
(45) Date of publication and mention of the grant of the patent: **07.08.2002**
(21) Application number: 95830169.9
(22) Date of filing: 28.04.1995
(51) Int. Cl.: F02P 1/00, F02P 17/00, G01R 29/027, G01R 31/38

(54) **Method and circuit for detecting the presence of a spark in internal combustion engine**
Methode und Schaltung zur Erkennung eines Zündfunkens in einer inneren Brennkraftmaschine
Méthode et circuit pour détecter la présence d'une etincelle dans un moteur à combustion interne

(43) Date of publication of application: 30.10.1996
(73) Proprietor: STMicroelectronics S.r.l., 20041 Agrate Brianza (Milano) (IT); DaimlerChrysler Corporation, Auburn Hills, Michigan 48326-2757 (US)
(72) Inventor: Palara, Sergio, I-95026 Acitrezza (Catania) (IT); Di Cicco, Ben, c/o SGS-Thomson Microelectr. Srl, I-20041 Agrate Brianza (Milano) (IT)
(74) Representative: Botti, Mario

(56) References cited:
- EP-A- 0 023 708
- EP-A- 0 386 431
- EP-A- 0 390 314
- EP-A- 0 654 604
- DE-A- 4 020 986

## Description

The present invention relates to a method for detecting the presence of a spark in an electronic ignition device for an internal combustion motor and to a related circuit.

It is known that in an electronic ignition device for an internal combustion motor there is the need to detect whether during the explosion phase a spark is present or absent on the secondary circuit of a spark coil inserted in the device.

If there is no spark it is necessary to proceed with subsequent operations to avoid deterioration of the catalytic muffler.

A known technical solution for meeting this necessity is described in European Patent Application 88108869.4. which suggests detecting the presence or absence of spark on the secondary circuit of the spark coil by analyzing the different behaviour or the voltage present on the primary circuit of the coil.

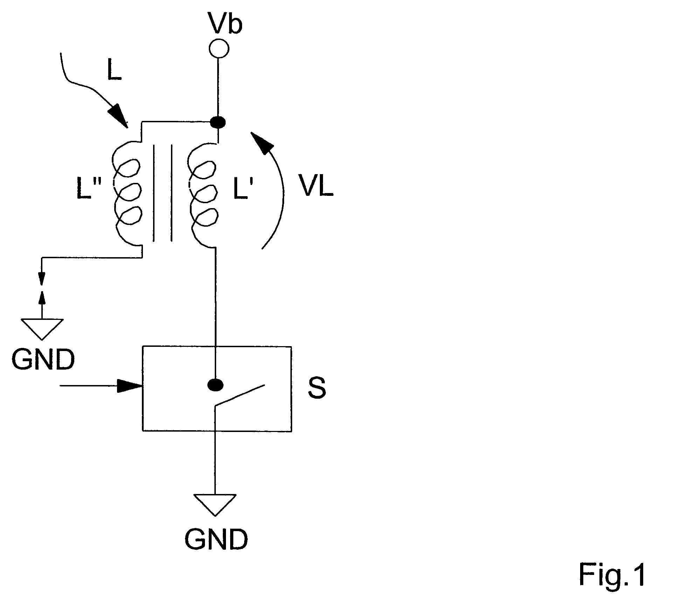

To clarify this phenomenon reference is made to FIG. 1.

When a controlled switch S inserted in the electronic ignition device of a internal combustion motor closes, in the primary circuit L' of the spark coil L passes a current whose behaviour is linearly increasing in time.

But when the controlled switch S opens, the voltage VL present on the primary circuit L' of the spark coil L increases rapidly to then settle after a certain period of time at a value equal to that of the supply voltage Vb supplied by the vehicle's battery.

In the latter case it can be noted that in the absence of spark on the secondary circuit L" of the spark coil L the duration of the overvoltage created on the primary circuit L' is approximately 100µs.

But in the presence of a spark the duration of the overvoltage is approximately 2ms.

The technical problem underlying the present invention is to provide a method and related circuit for correctly and accurately detecting a spark in an electronic ignition device of an internal combustion motor.

The technical problem is solved by a method and related circuit of the type indicated above and defined in the characterizing part of the annexed claims.

The characteristics and advantages of the method and related circuit in accordance with the present invention are set forth in the description of an embodiment thereof given below by way of non-limiting example with reference to the annexed drawings.

In the drawings:
FIG. 1 shows a diagram of principle of an electronic ignition device of an internal combustion motor,
FIG. 2 shows a block diagram of a circuit provided in accordance with the present invention, and
FIGS. 3, 4, 5, 6 and 7 show respective diagrams with the same time base of electrical signals present in the circuit in accordance with the present invention.

With reference to the FIGS. reference number 1 indicates as a whole and diagrammatically a circuit provided in accordance with the present invention for detecting the presence of a spark produced by means of a spark coil L inserted in an electronic ignition device of an internal combustion motor.

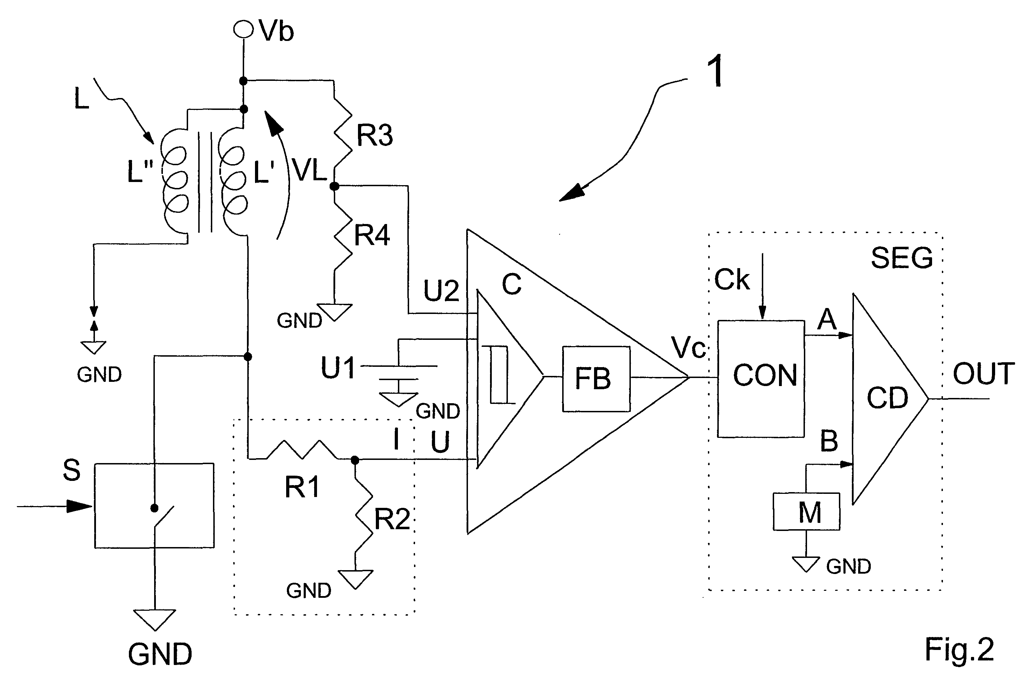

Specifically with reference to FIG. 2 the coil L comprises a primary circuit L' inserted between a power supply voltage generator Vb and a controlled switch S and a secondary circuit L".

Again with reference to FIG. 2 the circuit 1 also comprises a first input block I provided e.g. by means of a resistive divider (R1,R2) having an input terminal connected to the primary circuit L' of the coil L and an output terminal.

This circuit comprises also a comparator C with hysteresis having a first input terminal connected to the output terminal of the input block I.

The comparator also comprises a second and a third input terminals kept respectively at a first U1 and a second U2 reference voltage.

It is well to specify that this first reference voltage U1 and second reference voltage U2 represent respectively the upper and lower thresholds of the comparator C.

The second reference voltage U2 is obtained preferably by means of a resistive divider (R3,R4) connected to the supply voltage generator Vb.

At output the comparator C also comprises a low-pass filter FB.

The circuit 1 also comprises a second signalling block SEG having an input terminal connected to an output terminal of the comparator C and an output terminal which is an output terminal OUT in the drawing of the circuit 1.

This second signalling block SEG comprises in turn a counter CON having a first input terminal connected to the output terminal of the comparator C and a second input terminal receiving a timing signal Ck.

The counter CON has an output connected to an input of a digital comparator CD having a second input terminal connected to a memory element M in which is memorized a binary reference value B.

There is now described the operation of the circuit in accordance with the present invention with particular reference to an initial state in which the switch S is open.

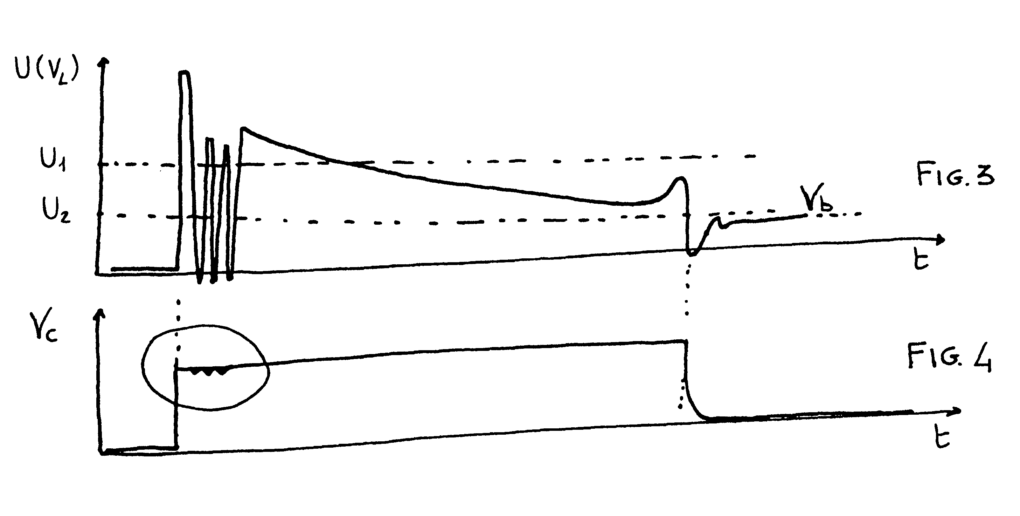

In this state it is seen that at the ends of the primary circuit L' of the spark coil L is present a voltage VL from which by means of the resistive divider (R1,R2) is obtained a proportional voltage U shown in FIG. 3.

The comparator C with hysteresis compares this voltage U with the upper threshold U1 and lower threshold U2.

Specifically, from the comparator C is output a voltage Vc which is at a high logic level when the voltage U exceeds the threshold value U1.

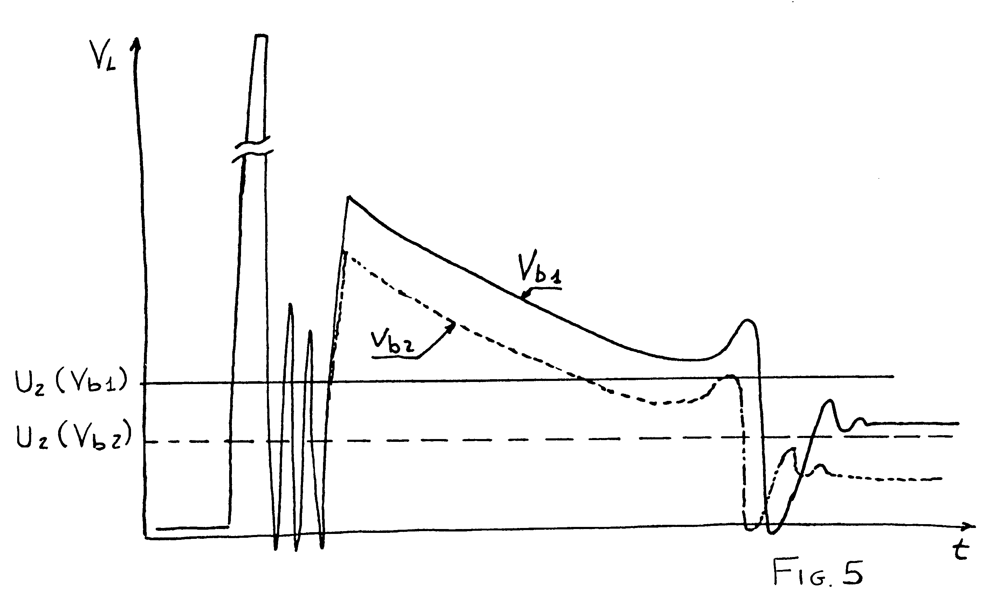

The voltage Vc by means of the filter FB keeps this logic level high for the entire duration of the transient until the voltage U falls below the lower threshold value U2 as shown in FIG. 4.

The duration of the voltage Vc is proportional to the duration of the overvoltage created on the primary circuit L' of the coil L when the controlled switch S opens.

It is also well to note that the height of the curve representing the behaviour of the voltage VL if there is a spark on the secondary circuit L" of the coil L depends strictly on the supply voltage Vb as shown in FIG. 5.

Consequently even the lower threshold U2 of the comparator C must be correlated with the supply voltage Vb.

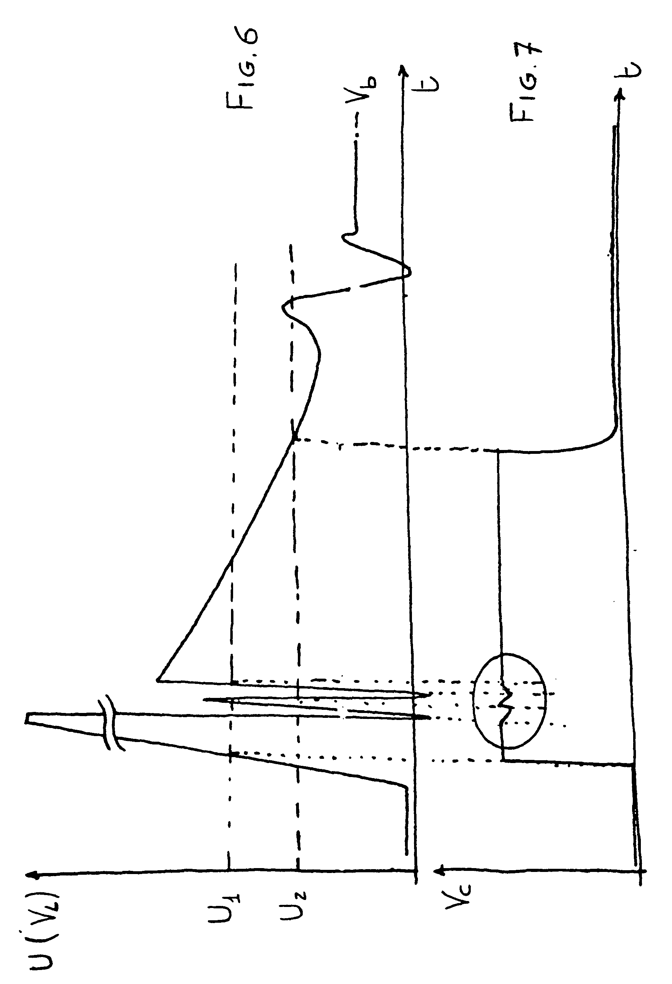

Indeed, as shown in FIGS. 6 and 7 if the threshold value U2 were constant and hence independent of the supply voltage Vb the duration of the voltage Vc would no longer be proportional to the duration of the overvoltage which there would be on the primary circuit L' of the coil L.

Thus, as the counter CON supplies at output a binary value A proportional to the duration of the voltage Vc this value A by means of the digital comparator CD is compared with the reference binary value B.

If A>B the digital comparator CD switches to a higher level and signals on the output terminal OUT of the circuit 1 the presence of the spark on the secondary circuit L" of the coil L.

## Claims

1. Method for detecting the presence of a spark produced by means of a spark coil (L) having a primary circuit (L') connected to a supply voltage generator (Vb) and a secondary circuit (L"), said spark coil (L) being inserted in an electronic ignition device of an internal combustion motor and said method being **characterized in that** it consists of the following phases:
- generating a first voltage signal (U) proportional to )a voltage (VL) present on the primary circuit of the spark coil (L),
- comparing said first voltage signal (U) with a first, upper, threshold value (U1) and in response producing a second voltage signal (Vc) at a first logic level when the first voltage signal (U) exceeds the first, upper, threshold value (U1),
- maintaining said second voltage signal (Vc) at the first logic level,
- comparing said first voltage signal (U) with a second, lower, threshold value (U2), proportional to the supply voltage (Vb), and in response producing the second voltage signal (Vc) at a second logic level when the first voltage signal (U) falls below the second, lower, threshold value (U2),
- detecting the time duration of the second voltage signal (Vc), and
- signalling the presence of a spark on the secondary winding if said time duration exceeds a reference value (B).

2. Method in accordance with claim 1 and **characterized in ;that** the phase of detecting the time duration of the second voltage signal (Vc) includes the phase of:
- generating a value (A) proportional to the time duration of the second voltage signal (Vc).

3. Method in accordance with claim 2 and **characterized in that** the phase of signalling the presence of a spark includes the phase of:
- producing an output value (OUT) at a high logic level when the time duration of the second voltage signal (Vc) exceeds the reference value (B).

4. Method in accordance with claim 1 and **characterized in that** the first, upper, threshold value (U1) is constant.

5. Method in accordance with claim 1 and **characterized in that** the first logic level is high and the second logic level is low.

## Patentansprüche

1. Verfahren zum Erfassen eines mittels einer Anregerspule (L) erzeugten Funkens, mit einem an einen Versorgungsstromgenerator (Vb) verbunden Primärkreis (L'), und einem Sekundärkreis (L"), wobei die Anregerspule (L) in einer elektronischen Zündvorrichtung eines Verbrennungsmotors eingesetzt ist, und wobei besagtes Verfahren **dadurch gekennzeichnet ist, dass** es folgende Schritte aufweist:
- Erzeugen eines ersten Spannungssignals (U), proportional zu einer im Primärkreis der Anregerspule (L) vorhandenen Spannung (VL);
- Vergleich zwischen dem ersten Spannungssignal (U) und einem ersten oberen Schwellwert (U1), und anschließendes Erzeugen eines zweiten Spannungssignals (Vc) mit einem ersten logischen Pegel, wenn der erste Spannungssignal den ersten oberen Schwellwert (U1) überschreitet;
- Aufrechthalten des besagten zweiten Spannungssignals (Vc) mit dem ersten logischen Pegel;
- Vergleich zwischen dem ersten Spannungssignal (U) und einem zweiten unteren Schwellwert (U2), proportional zur Versorgungsspannung (Vb), und anschließendes Erzeugen eines zweiten Spannungssignals (Vc) mit einem zweiten logischen Pegel, wenn der erste Spannungssignal den zweiten unteren Schwellwert (U2) unterschreitet;
- Erfassen der Zeitdauer des zweiten Spannungssignals (Vc); und
- Melden der Anwesenheit eines Funkens auf der sekundären Wicklung, falls besagte Zeitdauer einen Referenzwert (B) überschreitet.

2. Verfahren nach Anspruch 1, **dadurch gekennzeichnet dass** der Schritt des Erfassen der Zeitdauer des zweiten Spannungssignals (Vc) folgenden Schritt beinhaltet:
- Erzeugen eines zur Zeitdauer des digitalen Spannungssignals (Vc) proportionalen Wertes (A).

3. Verfahren nach Anspruch 2, **dadurch gekennzeichnet dass** der Schritt des Melden der Anwesenheit eines Funkens folgenden Schritt beinhaltet:
- Erzeugen eines Ausgangswertes (OUT), mit einem hohen logischen Pegel, wenn die Zeitdauer des zweiten Spannungssignals (Vc) einen Referenzwert (B) überschreitet.

4. Verfahren nach Anspruch 1, **dadurch gekennzeichnet dass** der erste obere Schwellwert (U1) konstant ist.

5. Verfahren nach Anspruch 1, **dadurch gekennzeichnet dass** der erste logische Pegel hoch und der zweite logische Pegel tief ist.

## Revendications

1. Méthode de détection de la présence d'une étincelle produite par une bobine d'excitation (L) ayant un circuit primaire (L') connecté à un générateur de tension d'alimentation (Vb) et un circuit secondaire (L"), ladite bobine d'excitation (L) étant insérée dans un dispositif d'allumage électronique d'un moteur à combustion interne et ladite méthode étant **caractérisée en ce qu'**elle comprend les phases de :
- générer un premier signal de tension (U) proportionnel à une tension (VL) présente sur le circuit primaire de la bobine d'excitation (L);
- comparer ce premier signal de tension (U) avec une première (U1) valeur de seuil supérieure et générer en réponse un deuxième signal de tension (Vc) à un premier niveau logique lorsque le premier signal de tension dépasse la première (U1) valeur de seuil supérieure;
- maintenir ledit deuxième signal de tension (Vc) au premier niveau logique;
- comparer ledit premier signal de tension (U) avec une deuxième (U2) valeur de seuil inférieure proportionnelle à la tension d'alimentation (Vb) et générer en réponse un deuxième signal de tension (Vc) à un deuxième niveau logique lorsque le premier signal de tension descend au-dessous de la deuxième (U2) valeur de seuil inférieure;
- détecter la durée temporelle du deuxième signal de tension (Vc); et
- signaler la présence d'étincelle sur l'enroulement secondaire si cette durée temporelle dépasse une valeur (B) de référence.

2. Méthode selon la revendication 1, **caractérisée en ce que** la phase de détection de la durée temporelle du deuxième signal de tension (Vc) comprend la phase de :
- générer une valeur (A) proportionnelle à la durée temporelle du signal de tension digital (Vc);

3. Méthode selon la revendication 2, **caractérisée en ce que** la phase de signalation de la présence d'étincelle comprend la phase de:
- produire une valeur de sortie (OUT) à un niveau logique élevé lorsque la durée temporelle du deuxième signal de tension (Vc) dépasse une valeur (B) de référence.

4. Méthode selon la revendication 1, **caractérisée en ce que** la première (U1) valeur de seuil supérieure est constante.

5. Méthode selon la revendication 1, **caractérisée en ce que** le premier niveau logique est haut et le deuxième niveau logique est bas.
